Europäisches Patentamt

European Patent Office

Office européen des brevets

(19)

(11) Publication number: **0 151 083 B1**

# EUROPEAN PATENT SPECIFICATION

(12)

(45) Date of publication of patent specification: 03.04.91    (51) Int. Cl.⁵: **G11C 11/56, H03K 17/693, G11C 7/00**

(21) Application number: 85400157.5

(22) Date of filing: 31.01.85

(54) Signal transmission circuit and storage device using such a circuit.

(30) Priority: 31.01.84 JP 15590/84

(43) Date of publication of application:
07.08.85 Bulletin 85/32

(45) Publication of the grant of the patent:
03.04.91 Bulletin 91/14

(84) Designated Contracting States:
**DE FR GB**

(56) References cited:
**EP-A- 0 044 978**
**EP-A- 0 078 439**
**US-A- 3 601 634**

(73) Proprietor: **FUJITSU LIMITED**
**1015, Kamikodanaka Nakahara-ku**
**Kawasaki-shi Kanagawa 211(JP)**

(72) Inventor: **Suzuki, Yasuo**
**11-16, Shiratoridai Midori-ku**
**Yokohama-shi Kanagawa 227(JP)**

(74) Representative: **Descourtieux, Philippe et al**
**CABINET BEAU de LOMENIE 55 rue**
**d'Amsterdam**
**F-75008 Paris(FR)**

## Description

The present invention relates to a signal transmission circuit having a plurality of input terminals and a common output terminal for transmitting an input signal pulse without substantial deformation of the inputed signal pulse profile. Particularly, it relates to a simplified signal transmission circuit for use in a semiconductor storage device for comparing an output of a real storage cell with that of a reference cell.

Due to the rapid development of electronic devices, such as semiconductor storage devices, there occurs a demand for a signal transmission circuit having multi-input terminals and a common output terminal to transmit an input signal without any distortion of the pulse profile and with satisfactory timing. This is in particular the case for a multi-state read only memory (ROM), wherein the output voltage of a real storage cell is compared with output voltages of associated reference cells to detect the level of the stored information. A more detailed description of a multi-state ROM is given in the following.

Recently, the demand for a storage device having high capacity has been increasing. A character generator for KANJI, for example, requires a MASK ROM having a capacity of 1 to 2 M bits. Accordingly, the direction of evolution for semiconductor storage devices has been to increase the number of storage elements per unit area on a semiconductor chip. For this purpose, various technologies for metal-oxide-semiconductor (MOS) devices have been developed to minimize the dimension of elementary devices such as MOS field effect transistors (FETs), conducting paths and the like, but there is a technical limitation. In order to overcome this limitation, multi-state storage cells come to be used instead of prior art binary storage cells, because a four state, quaternary, FET ROM, for example, is capable of storing twice as much information per unit area as a conventional binary ROM having the same number of storage devices per unit area on a semi-conductor chip. Multi-state storage devices having multi-state FETs are reported in Electronics, October 9, 1980, page 39 by John G. Posa, and Electronics, June 30, 1982 by J. Robert Lineback.

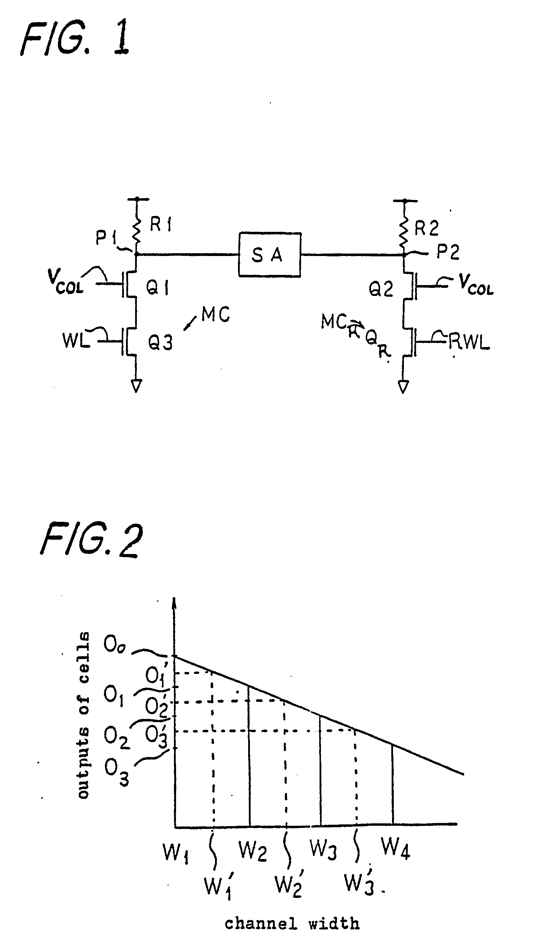

Fig. 1 is a partial circuit diagram showing how the quaternary storage information is detected. The FETs $Q_3$ used for the four state storage cells MC (hereinafter real cells) have each one of four different conductances, $gm_0$ to $gm_3$, storing four different storage states, "0", "1", "2" and "3" respectively. These different conductances gms are provided by varying the resistance of channels of the FETs $Q_3$. There are several ways for varying the conductance gm of a FET. Throughout this document, FETs of different conductances are obtained by providing different channel widths W, including the channel $W = O$. Three different reference voltages are produced by reference FETs $Q_R$. One reference FET $Q_R$ composes one reference cell $MC_R$. The conductances of the reference FETs $Q_{R1}$ to $Q_{R3}$ are respectively $gm_1'$, $gm_2'$, and $gm_3'$, with

$gm_0 < gm_1' < gm_1 < gm_2' < gm_2 < gm_3' < gm_3$ The corresponding channel widths $W_0$ to $W_3$ and $W_1$ to $W_3$, satisfy the relation expressed by

$W_0 < W_1' < W_1 < W_2' W_2 < W_3' < W_3$

Fig. 2 illustrates the relation between the outputs O of the cells and the channel widths W. It can be seen that the three outputs $O_1'$ to $O_3'$ of the reference cells $Q_{R1}$ to $Q_{R3}$ divide the output range from $O_0$ to $O_3$ into four portions.

When reading out the storage information, the real cell and the corresponding reference cells are selected by applying a column selection signal $V_{COL}$ to the gates of transfer FETs $Q_1$ and $Q_2$ to make the FETs $Q_1$ and $Q_2$ conductive, and $Q_3$ and QR are connected to the corresponding load resistors $R_1$ and $R_2$ through column lines. Then, selection signals $V_{WL}$ and $V_{RWL}$ are applied to the gates of the FETs $Q_3$ and $Q_R$ through the word line WL and the reference word line RWL, respectively. Thus, the outputs O and O' of the cells are available at the nodes $P_1$ and $P_2$. The output of a real cell is thus compared simultaneously with the outputs from three reference cells $Q_{R1}$ to $Q_{R3}$ by means of three sense amplifiers $SA_1$ to $SA_3$ respectively (not shown), and a set of the three outputs of the sense amplifiers discriminates the level of the output O of the real cell.

The FETs used for real cells and reference cells are assumed to have almost the same characteristics except their conductances, namely their channel widths. As a result, the reference cells serve to provide reference outputs, namely reference voltages, as long as the same gate voltage is applied to the gates of the FETs in the real cells and reference cells at any moment. As stated before, the real cell and the corresponding reference cell are selected by a word line signal rising from zero level, whereby the word line signal votage should be applied to the gates of the FETs of both cells exactly in the same way : maintaining the same change with time, namely the same signal shape (a wave profile). Usually the word lines are formed of poly-crystalline silicon, having a relatively high resistivity. As a result, due to a distributed parasitic capacitance along the word line, there is a significantly large time delay in the transmission of signals to each of the storage cells along the word line. This time delay is inevitable. In order to eliminate the gap of time delay between the respective word line signals at a reference cell and at the corresponding real cell, both of which belong to the same column, each row of the reference cells has a same number of cells and a similar word line as those of the corresponding row of real cells. The row of reference cells including its word line is formed as if it was a duplicate of a row of real cells. With this configuration, almost the same time delay occurs at a real cell and at the corresponding reference cell which are located at the same column. In addition, the profile of the word line signals is not the same, the reason of which will be described later. These are the reasons why almost the similar circuit elements, word lines and cell FETs, have been formed in the prior art reference and dummy cell arrays to avoid distortion, decay and time lag of the transmitting word line signals.

This almost doubled configuration of the reference circuits occupies a large surface area of the substrate, adversely affecting the high packaging density of the storage device.

Of course, a fixed voltage, a power source voltage Vcc for instance, can be applied to the gate of the FETs of the reference cells to create a fixed reference voltage. In this case, the rising word line signal should be applied to the gates of the FETs of the real cell until the signal reaches its final value, nearly Vcc, utilizing a strobe signal. This requires a relatively long time resulting in a longer access time.

## SUMMARY OF THE INVENTION

It is an object of the present invention to provide a signal transmission circuit having a plural input terminal and a common output terminal, for transmitting an input signal without any change of signal profile and with practically negligible time delay.

It is another object of the present invention to provide a storage device such as a masked read only memory having multi state storage cells with a high packing density by reducing the number of the reference cells and associated word lines.

It is still another object of the present invention to provide a storage device such as a binary level read only memory having reference cells for detecting low level output signals of its storage cells with a higher packing density by reducing the number of the reference cells and associated word lines.

These objects, features and advantages of the present invention are accomplished by an improved signal transmission circuit comprising, according to the invention, a common output terminal, wherein each of said input circuits comprises :

- an input terminal ;
- a buffer circuit ; and

- a metal insulator semiconductor (MIS) transistor, the source region and drain region of said MIS transistor being connected to said input terminal and said output terminal,
- said buffer circuit being inserted between said input terminal and the gate electrode of said MIS transistor, and being driven by an input signal applied selectively to said input terminal, and
- said MIS transistor being driven by said buffer circuit to be made conductive, thereby allow ing input signal to be transmitted from said input terminal to said output terminal selectively.

As mentioned hereinbefore, in electronic devices, such as a MOS read only memory, there is a demand for a signal transmission circuit having multi-input signal terminals and a common output terminal, so that an input signal applied to one of multi-input signal terminals can be transmitted to the common output terminal with the least possible deformation and delay, without any outside interference. A typical example is a quaternary-state MOS ROM, wherein a signal pulse is applied simultaneously to a gate of a FET of a real memory cell and to the gates of reference cells to compare the values of the outputs of the cells. These two pulse signals transmitted along word lines, should be completely identical with respect to time and signal magnitude, otherwise the reference cell cannot provide a correct reference voltage, as described before.

Therefore, in a prior art four state ROM, for instance, three blocks of reference cells are provided having the complete duplicated construction of a real storage block, and therefore occupying a considerable large area on the chip. It is desirable that the number of word lines and the number of rows of reference cells and dummy cells be minimized, such as by having a common word line and a common row of reference cells or dummy cells, in order to save the surface area of the substrate of the ROM (a block of dummy cells comprising several rows is used for checking the arrival of a transmitting input signal at the end of the row).

A signal transmission circuit making it possible to realize this arrangement is now discussed. With a transmission circuit comprising multi input terminals simply connected to a common output terminal, interference will occur between an input signal applied to one of the input terminals and other signals applied to another terminal, and the output signal profile will be deformed. With another circuit wherein multi input terminals are connected through respectively diodes to a common output terminal, the interference between input signals can be eliminated but the output signal profile is distorted by the diodes. If each of the multi input terminals is connected to the common output terminal through a respective MOS FET instead of a diode, the problem described above can be eliminated, however, additional control signals to be applied to the gates of the FETs are necessary, resulting in a more complicated circuit configuration and a cost increase of the device.

The above-mentioned problem is solved by the signal transmission circuit according to the present invention. In the circuit of the present invention, each input terminal is connected to the output terminal through a MIS transistor (in particular a MOS FET such as an enhanced p-type MOS FET), which is kept non-conductive when no input signal is applied to the input terminal, whereby the input terminal is isolated from other input and output terminals. When an input signal is applied to one of the input terminals, the associated MIS transistor is made conductive, namely, is opened, by the input signal itself. It should be noted that the MIS transistor must be fully opened immediately after the arrival of the input signal. If the input signal is directly applied to the gate of the MIS transistor, the latter cannot be opened immediately, due to its threshold voltage, and is not conductive until the gate voltage exceeds the threshold voltage. Furthermore, the input signal applied to the gate may be not sufficiently high to make the MIS transistor fully conductive. In order to provide a definitely high input signal with lesser time delay to the gate of the MIS transistor to open the latter, a buffer circuit is inserted forming a wave shaping circuit. The buffer circuit is for example in the form of one or several c-MOS inverters. With the aid of the buffer circuit, the signal pulse applied to the gate of the MIS transistor is sufficiently low to make this transistor substantially conductive. Thus, the signal pulse can be transmitted from the input terminal to the output terminal keeping almost the same signal profile and having a negligible time delay.

The signal transmission circuit according to the present invention is also applicable to a binary state storage device, wherein output signals from real cells are compared with reference signals provided by reference cells, in order to obtain a high sensing speed.

As described above, a transmission circuit according to the present invention makes it possible to transmit a signal applied to one of plural input terminals to a common output terminal, without providing or receiving any influence to or from other input terminals, and while maintaining the profile of the signal throughout the transmission with practically negligible time delay. Accordingly, the transmission circuit can be applied to electronic devices, particularly to storage devices, resulting in a vast saving of circuits and elementary devices such as word lines and reference storage cells.

This leads to a cost reduction and an improvement for obtaining a higher packing density of a storage device.

The present invention will be more readily understood from a reading of the following description made with reference to the accompanying drawings.

## BRIEF DESCRIPTION OF THE DRAWINGS

Fig. 1 is a circuit diagram showing schematically a storage cell and a corresponding reference cell to explain how a multi-state storage information is detected,

Fig. 2 is a diagram illustrating the relation between the channel width and the output of a field effect transistor,

Fig. 3 is a circuit diagram of an embodiment of a signal transmission circuit, according to the present invention,

Fig. 4 is a time chart showing a clock signal and input and output signals of the transmission circuit of Fig. 3,

Fig. 5 is a circuit diagram of another embodiment of a signal transmission circuit according to the present invention,

Fig. 6 is a functional block diagram of a four-state MOS read only memory (ROM), having blocked storage cells and reference cells,

Fig. 7 is a circuit diagram of one of the real storage block of the ROM shown in Fig. 6,

Fig. 8 is a circuit diagram of a prior art reference cell block of the ROM of Fig. 6, and

Fig. 9 is a schematic circuit diagram of a reference block of the ROM shown in Fig. 6, having a signal transmission circuit according to the present invention.

## DESCRIPTION OF THE PREFERRED EMBODIMENTS

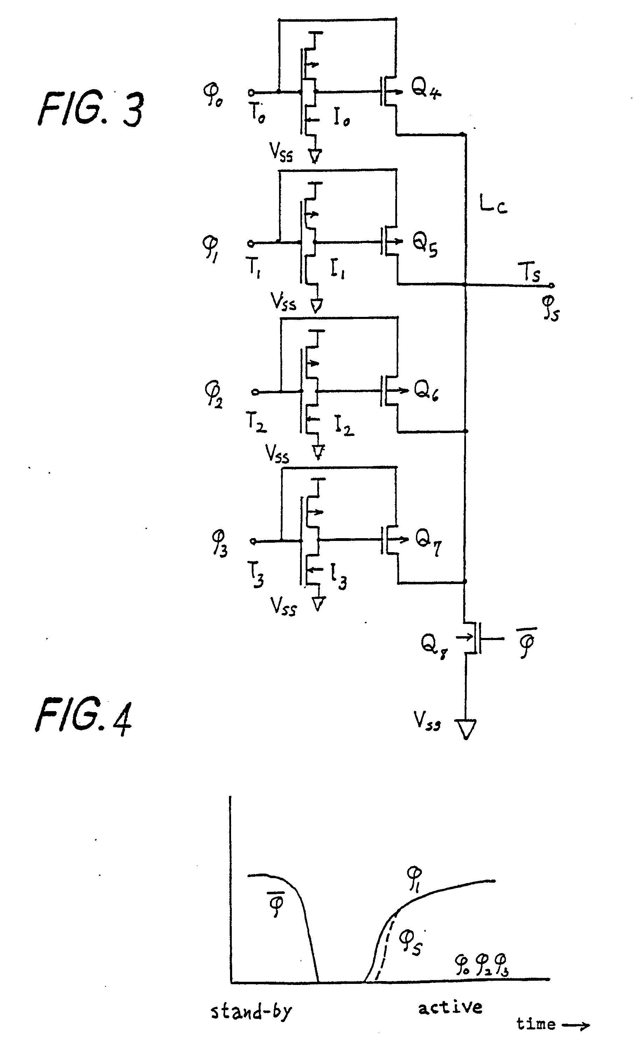

Fig. 3 is a circuit diagram of an embodiment of the present invention. For sake of simplicity, it is assumed that, in this embodiment, the circuit has four CMOS inverters $I_0$ to $I_3$, four MIS transistors such as p-type MOS FETs $Q_4$ to $Q_7$ and an n-type MOS FET $Q_8$. The reference letters $\phi_0$ to $\phi_3$ denote input signals applied to input terminals $T_0$ to $T_3$ which correspond to the four word lines of a storage block, which will be described later. The inverters $I_0$, $I_1$, $I_2$, $I_3$ connect this input terminals $T_0$, $T_1$, $T_2$, $T_3$ respectively to the sources of the FETs $Q_4$ to $Q_7$. The drains of the FETs $Q_4$ to $Q_7$ are jointly connected to a common output line Lc, which is connected to an output terminal $T_S$ and to a power source Vss (usually a ground source) through the

transistor $Q_8$. When all input signals are at low level, the outputs of the inverters $I_0$ to $I_3$ are at high level and the transistors $Q_4$ to $Q_7$ are non-conductive. A clock signal $\bar{\phi}$ issued from a reset circuit is at high level, as shown in the time chart of Fig. 4, making the transistor Q8 conductive to discharge residual charges on the output terminal Ts to the ground. As a result, the output terminal Ts is at low level. When the reset signal $\bar{\phi}$ is turned to active state (low level) and the transistor $Q_8$ becomes non-conductive, the circuit is ready for transmitting signals.

When the input terminal $T_1$, for instance, is selected and other terminals are left non-selected, the gate voltage of the inverter $I_1$ and the source voltage of the transistor $Q_5$ start to rise. The output of only the inverter $I_1$ decreases to a low level and the outputs of the other inverters remain at high level. This leads to make the transistor $Q_5$ definitely conductive and the other transistors $Q_4$, $Q_6$ and $Q_7$ non-conductive, resulting in the transmission of the input signal $\phi_1$ from the input terminal $T_1$ to the output terminal $T_s$, producing an output signal $\phi_s$. The output signal $\phi_s$ keeps almost the same profile as that of the input signal $\phi_1$. This is because the driving action of the inverters $I_1$ is substantially quick and the output voltage is sufficiently low. The output signal $\phi_s$ is slightly delayed due to a threshold voltage of the inverter $I_1$ but it is negligibly small as shown in the time chart of Fig. 4. Thus, the input signal $\phi_1$ is transmitted to the output terminal $T_s$ with the almost same signal profile and a negligible time lag. After transmission of the signal, the potential of the terminal $T_1$ falls to low level and the output of the inverter $I_1$ returns to high level. Thus, the transistor $Q_5$ becomes again non-conductive. In the same way, other input signals $\phi_0$, $Q_2$, $Q_3$ applied to the respective input terminals $T_0$, $T_2$, $T_3$, can be transmitted individually.

This transmission circuit is applicable to a storage device such as a read only memory having a plurality of rows of reference storage cells and their associated word lines. By the use of the above-mentioned transmission circuit, a single word line and a single row of reference cells are sufficient to create a reference signal, resulting in a remarkable saving of word lines and reference storage cells. The case is the same with the dummy storage block.

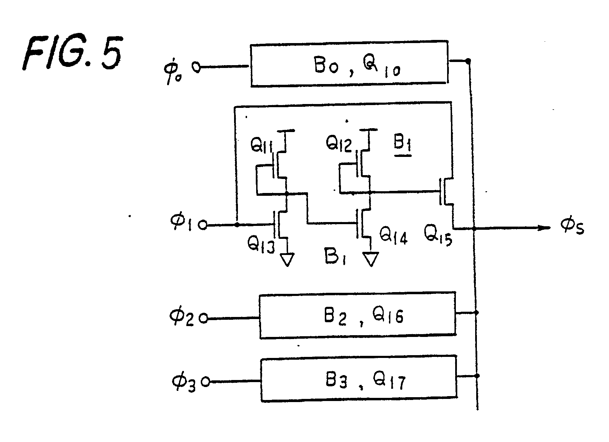

The above-mentioned gate transistors $Q_4$, $Q_5$,.... are p-type transistors. When n-type transistors are used instead of the above p-type transistors, the inverters used in the transmission circuit must be doubled in order to provide the gate of the n-type transistor with a positive signal to make it conductive. The circuit configuration is shown in Fig. 5. Transistors $Q_{11}$, $Q_{12}$ are depletion type

FETs with commonly connected gate-source region, and transistors $Q_{13}$, $Q_{14}$ are enhanced type FETs. The pairs of two transistors, $Q_{11}$, $Q_{13}$ and $Q_{12}$, $Q_{14}$ compose two double inverters. This is regarded as a buffer denoted as $B_1$. The other buffers $B_0$, $B_2$,... are built in the same way. $Q_{10}$, $Q_{15}$, $Q_{16}$ and $Q_{17}$ denote n-type FETs.

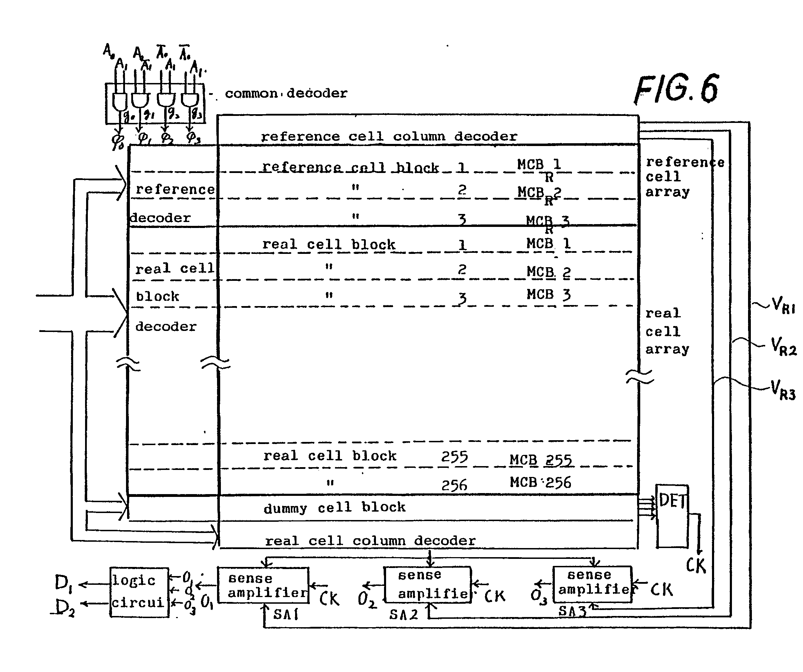

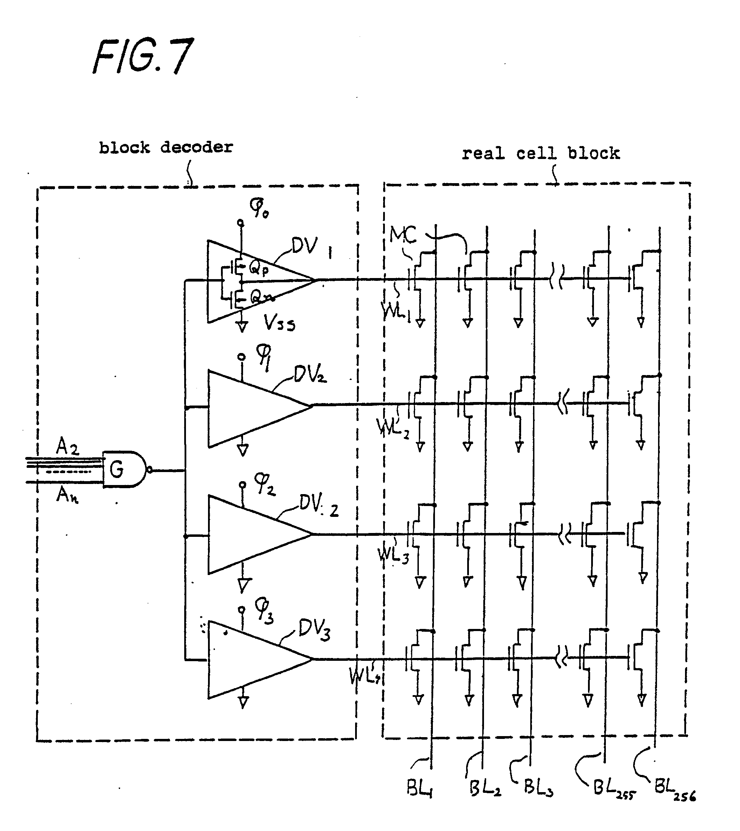

Fig. 6 is a functional block diagram of a modern four-state storage device of 2 M bits capacity. The device illustrated in Fig. 6 has a two bits output. For eight bits output, four devices as the one of Fig. 6 are formed on a substrate. The illustrated storage device comprises a real cell array divided into 256 blocks MCB 1 to MCB 256, and a reference array of three blocks $MCB_R1$ to $MCB_R3$, for creating three reference voltages. A circuit configuration of the real cell block and its block decoder is shown in Fig. 7. Each block comprises four rows of storage cells MC, four associated word lines $WL_1$ to $WL_4$ and 256 bit lines $BL_1$ to $BL_{256}$. To one bit line, 256X4 real cells MC belonging to one column are connected. To each real cell block MCB is connected a respective block decoder, comprising four drivers $DV_1$ to $DV_4$ and a NAND-gate G. The four drivers $DV_1$ to $DV_4$ are driven by four input signals $\phi_0$ to $\phi_3$ respectively fed from a common decoder (shown in Fig. 6), which commonly drives three reference block decoders, one of 256 real block decoders and one dummy cell block decoder. The common decoder is composed of four AND-gates $g_0$ to $g_3$. To each AND-gate, as shown in Fig. 6, address signals $A_0$, $\bar{A}_0$, $A_1$ and $\bar{A_1}$ are inputed and, depending upon the combination of the four inputed signals, one of output signals $\phi_0$ to $\phi3$ is outputed. Accordingly, corresponding to a combination of the four address signals, one of the signals $\phi_0$ to $\phi_3$ is selected to be of high level.

The operation of the real cell block will be now briefly discussed with reference to Fig. 6 and Fig. 7. At first, a real cell block is selected by an address signal through the NAND-gate G, setting the output of the gate at a low level. Then by other address signals $A_0$ to $\bar{A}_1$, one of the AND-gates $g_0$ to $g_3$ is selected and the output of the selected gate, $\phi_0$ for example, is set at high level while the others are all at low level. The low level output of the NAND-gate G is applied to the gates of the p-type FET $Q_p$ and n-type FET $Q_n$ of each one of the cell real block drivers $DV_1$ to $DV_4$, causing the FET $Q_p$ to be conductive and the FET $Q_n$ to be non-conductive. At this state, the signal $\phi_0$ which is rising up, is transmitted to the word line $WL_1$. Thus, the potential of the word line $WL_1$ rises up, and the row is selected. Of course, the other three FETs $Q_p$ are conductive, but the applied signals $\phi_1$ to $\phi_3$ are at low level, and the word lines $WL_2$ to $WL_4$ remain at low level, non-selected. The output of the non-selected NAND gates of the other real cell blocks is kept at high level, and each p-type FET $Q_p$ is non-conductive, isolating the associated word line from the other word lines. Each n-type FET $Q_n$ is conductive forcing down the associated word line to the ground potential.

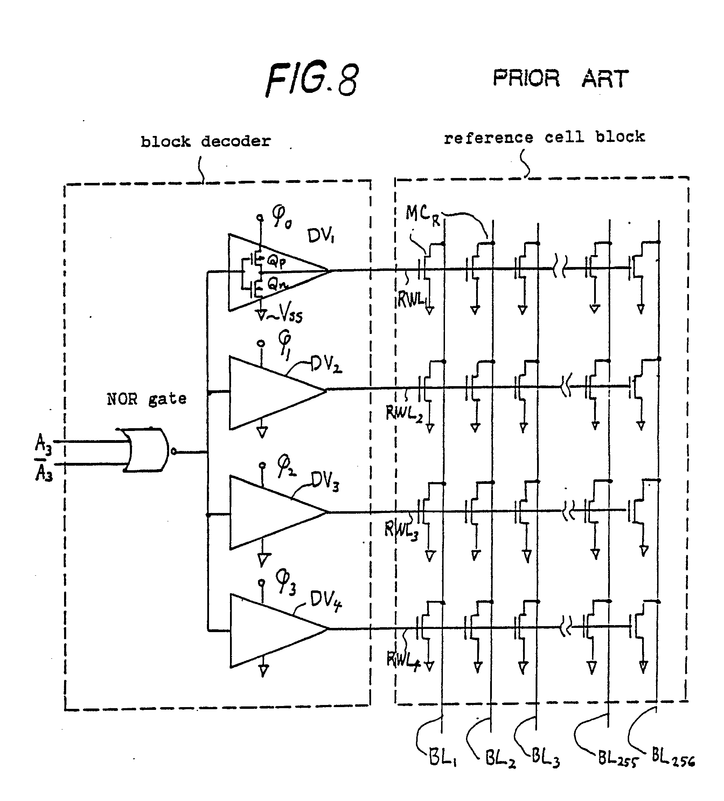

A block diagram of a prior art reference cell block is illustrated in Fig. 8. Each reference cell block has four word lines and four rows of reference cells like the real cell block described above. The three reference cell blocks provide three different reference voltages by using each four rows of reference FETs. The FETs of each row have each a respective channel width corresponding to the reference voltage to be created. However, except the channel width of the reference FETs, all other elements of the word lines and reference cells are formed quite the same as those of the real cell blocks. This is because the input signals $\varnothing_0$ to $\varnothing_3$ are not the same but show some small differences due to the following facts. The word line signals $\varnothing_0$ to $\varnothing_3$ are created by using a different combination of address signals $A_0$, $\overline{A}_0$, $A_1$ and $\overline{A}_1$, as described before. In addition, the AND-gates $g_0$ to $g_3$ are not formed quite identically because of the limita tion of space on the substrate. Therefore, the selection of a real cell and of the three reference cells should be performed by using the same word line signal. For example, the real word line $WL_1$ and the reference word line $RWL_1$ should be selected by using the same word line signal $\varnothing_0$. Thus, for both real and reference cell blocks, four word lines and four rows of cells are formed in a similar arrangement.

The three reference cell blocks, of course, should be selected every time a real cell block is selected. Therefore, adress signals, $A_2$ and $\overline{A_3}$, for example, are always allotted for the reference block.

The dummy cell block has a single word line and four rows of dummy cells, having the same configuration as that of a real cell block, except that all the dummy cells have a widest channel, because the dummy cell block is used for simulating the rising condition of the word line signal voltage under the worst circumstances, for checking the completion of the transmission of the signal along the word line.

The operation of the four-state storage device having prior art reference blocks, partially shown in Fig. 6, will now be described. By a combination of address signals, one of the real cell blocks MCB 1 to MCB 256 is selected. By causing the level of one of $\varnothing_0$ to $\varnothing_3$ signals to rise, one of the word lines of the selected real cell block is selected, whereby the outputs of the selected real cells are outputed to the bit lines $BL_1$ to $BL_{256}$, one of which being selected by a column decoder (shown at the bottom side of Fig. 6) and fed to three sense amplifiers $SA_1$, $SA_2$ and $SA_3$. At the same time, all the reference cell blocks are selected, because the three reference voltages are always necessary. Then, the word lines and bit lines of the reference cell blocks corresponding to that of the real cell block are selected. The three selected reference signals $V_{R1}$ to $V_{R3}$ are respectively fed to the three sense amplifiers. The two signals inputed to each sense amplifier are compared to each other to output a signal representative of the difference between the two inputed signals, in order to discriminate the level of the output of each selected real cell.

Similarly, the dummy cell block is always selected and the selection of four word lines is performed in the same way as in the case of the reference cell blocks. A detector DET is connected at the end of the dummy word line for sensing the rising up to a predetermined of the potential at the end of the dummy word line. Once this rising sensed by the detector, a clock signal CK is outputed to activate the sense amplifiers $SA_1$ to $SA_3$ and cause the amplifiers to issue outputs $O_1$, $O_2$ and $O_3$, respectively. These outputs correspond to the FET of the real cell selected, denoting the states "0", "1", "2" or "3" : "000", "100", "110" or "111". The outputs $O_1$, $O_2$ and $O_3$ are processed by a logic circuit to be converted to binary-state signals.

As described in detail, almost a duplicated circuit configuration is used for the three reference cell blocks and the dummy cell block in a prior art four-state read only device.

As a result, significantly large area is devoted to these circuits.

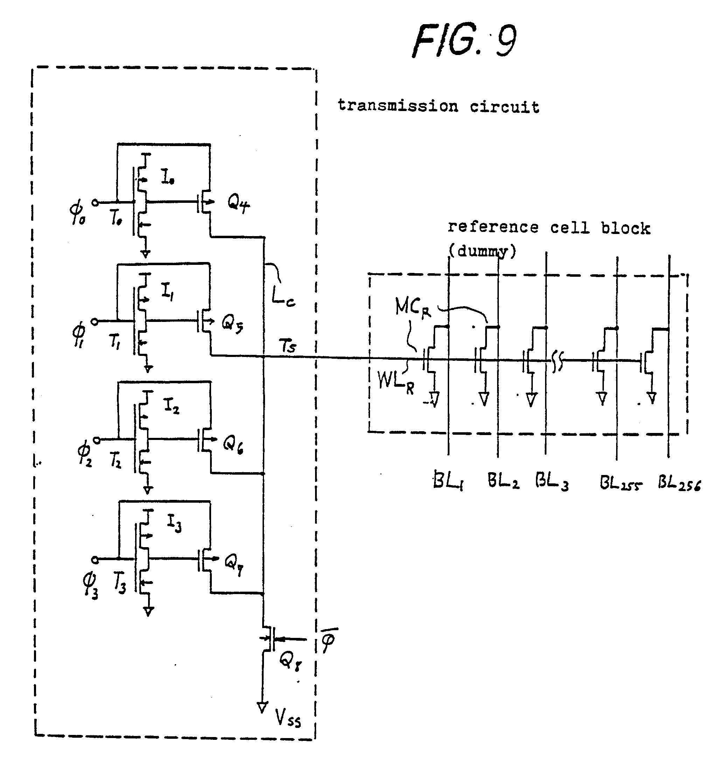

Now, the transmission circuit according to the present invention is applied to the reference storage blocks and dummy blocks of the four-state read only memory to reduce the four word lines and four rows of cells to a single word line and a single row of cells. Fig. 9 is a schematic wiring diagram of a reference storage block using a transmission circuit according to the present invention as shown in Fig. 3. Same reference letters and numerals denote same parts in Fig. 8 and Fig. 9.

The four input terminals shown in Fig. 3 correspond to the four word lines of each of the three reference blocks or of one dummy block. As it is clearly apparent from Fig. 9, a single row of reference storage cells $MC_R$ and a single word line $WL_R$ are used instead of four rows of cells and four word lines. When any of input signals $\varnothing_0$ to $\varnothing_3$ is caused to rise, the same driving signals are applied simultaneously to a selected real cell and to corresponding (at the same column) reference cells $MC_R$ of the three reference blocks. Mutually corresponding real cell MC and three reference cells

$MC_R$ located at the same column, are driven by respective driving signals. It is clear that the selected driving signals have almost no distortion and that the signals are transmitted along the word lines in the selected row of real cells, in the three rows of reference cells and in the row of dummy cells with the same speed, producing no time gap between the transmitted signals. By applying the present invention to the read only memory shown in Fig. 6, nine word lines for the reference blocks and three word lines for the dummy block can be omitted. In addition, 256X12 pieces of storage cells can be saved. These provides the read only memory with a significantly improved high packing density and cost reduction.

So far, the application of the transmission circuit according to the present invention has been described with regards to storage devices, but it is obvious to those skilled in the art that the use of the transmission circuit is not confined to the devices described above, but can be extended to various other apparatuses.

## Claims

1. A signal transmission circuit comprising a common output terminal (Ts) and a plurality of input circuits being jointly connected to said common terminal, wherein each of said input circuits comprises :
   - an input terminal ($T_0$, $T_1$, $T_2$, $T_3$)
   - a buffer circuit ($I_0$, $I_1$, $I_2$, $I_3$); and
   - a metal insulator semiconductor (MIS) transistor ($Q_4$, $Q_5$, $Q_6$, $Q_7$), the source region and drain region of said MIS transistor being connected to said input terminal and said output terminal,
   - said buffer circuit being inserted between said input terminal and the gate electrode of said MIS transistor, and being driven by an input signal ($\phi_0$, $\phi_1$, $\phi_2$, $\phi_3$) applied selectively to said input terminal, and
   - said MIS transistor being driven by said buffer circuit to be made conductive, thereby allowing said input signal to be transmitted from said input terminal to said output terminal selectively.

2. A signal transmission circuit according to Claim 1, wherein said MIS transistor ($Q_4$, $Q_5$, $Q_6$, $Q_7$) is of p-type channel type and said buffer circuit comprises a cMOS inverter ($I_0$, $I_1$, $I_2$, $I_3$).

3. A signal transmission circuit according to Claim 1, wherein said MIS transistor ($Q_{10}$, $Q_{15}$, $Q_{16}$, $Q_{17}$) is of n-type channel type and said buffer circuit ($B_0$, $B_1$, $B_2$, $B_3$) comprises two cMOS inverters connected in series.

4. A storage device comprising :
   a real storage cell array forming a matrix comprising a plurality of rows of real storage cells, (MC) for storing information;
   a reference storage cell array comprising a plurality of rows of reference storage cells (MCR) for creating reference signals ($V_{r1}$, $V_{r2}$, $V_{R3}$), each reference row creating one of a predetermined number of reference signals ;
   a row of dummy storage cells each for simulating the transmission of a word line signal ($\phi_0$, $\phi_1$, $\phi_2$, $\phi_3$) applied to said row of real storage cells and said row of reference cells; and
   a signal transmission circuit for transmitting said word line signal ($\phi_0$, $\phi_1$, $\phi_2$, $\phi_3$) simultaneously to a selected row of real storage cells, all rows of said reference storage cells and said row of dummy storage cells, characterized in that said signal transmission circuit (Fig. 9) comprises a common output terminal (TS) and a plurality of input circuits being jointly connected to said common output terminal, each of said input circuits comprising : an input terminal($T_0$, $T_1$, $T_2$, $T_3$),a buffer circuit ($I_0$, $I_1$, $I_2$, $I_3$) and a metal insulator semi-conductor (MIS) transistor ($Q_4$, $Q_5$, $Q_6$, $Q_7$), the source region and drain region of said MIS transistor being connected to said input terminal and said output terminal, said buffer circuit being inserted between said input terminal and the gate electrode of said MIS transistor said buffer circuit being driven by said word line signal ($\phi_0$, $\phi_1$, $\phi_2$, $\phi_3$) applied selectively to said input terminal, and said MIS transistor being driven by said buffer circuit to be made conductive, thereby causing said word line signal to be transmitted from said input terminal to said output terminal selectively.

## Revendications

1. Circuit de transmission de signal comprenant une borne de sortie commune (Ts) et plusieurs circuits d'entrée reliés en commun à ladite borne commune, où chacun desdits circuits d'entrée comprend:
   - une borne d'entrée ($T_0$, $T_1$, $T_2$, $T_3$),
   - un circuit tampon ($I_0$, $I_1$, $I_2$, $I_3$), et

- un transistor de type métal-isolant-semi-conducteur (MIS) ($Q_4$, $Q_5$, $Q_6$, $Q_7$), les régions de source et de drain dudit transistor MIS étant connectées à ladite borne d'entrée et à ladite borne de sortie,
- ledit circuit tampon étant inséré entre ladite borne d'entrée et l'électrode de grille dudit transistor MIS, et étant commandé par un signal d'entrée ($\Theta_0$, $\Theta_1$, $\Theta_2$, $\Theta_3$) appliqué de façon sélective à ladite borne d'entrée, et
- ledit transistor MIS étant commandé par ledit circuit tampon afin d'être rendu conducteur, ce qui permet de transmettre de façon sélective ledit signal d'entrée de ladite borne d'entrée à ladite borne de sortie..

2. Circuit de transmission de signal selon la revendication 1, où ledit transistor MIS ($Q_4$, $Q_5$, $Q_6$, $Q_7$) a un canal de type p et où ledit circuit tampon comprend un inverseur de technologie C-MOS ($I_0$, $I_1$, $I_2$, $I_3$).

3. Circuit de transmission de signal selon la revendication 1, où ledit transistor MIS ($Q_{10}$, $Q_{15}$, $Q_{16}$, $Q_{17}$) a un canal de type n et où ledit circuit tampon ($B_0$, $B_1$, $B_2$, $B_3$) comprend deux inverseurs de technologie C-MOS connectés en série.

4. Dispositif de mémorisation comprenant:
- un réseau de cellules de mémoire réelles constituant une matrice comportant plusieurs rangées de cellules de mémoire réelles (MC) afin de mémoriser des informations,
- un arrangement de cellules de mémoire de référence comportant plusieurs rangées de cellules de mémoire de référence ($MC_R$) afin de produire des signaux de référence ($VR_{R1}$, $VR_{R2}$, $V_{R3}$), chaque rangée de référence produisant un parmi un nombre prédéterminé de signaux de référence,
- une rangée de cellules de mémoire factices, chacune servant à simuler la transmission d'un signal de ligne de mot ($\Theta_0$, $\Theta_1$, $\Theta_2$, $\Theta_3$) appliqué à ladite rangée de cellules de mémoire réelles et à ladite rangée de cellules de référence, et
- un circuit de transmission de signal pour transmettre simultanément ledit signal de ligne de mot ($\Theta_0$, $\Theta_1$, $\Theta_2$, $\Theta_3$) à une rangée de cellules de mémoire réelles sélectionnée, à toutes les rangées desdites cellules de mémoire de référence et à ladite rangée de cellules de mémoire factices, caractérisé en ce que ledit circuit de transmission de signal (Figure 9) comprend une borne de sortie commune (Ts) et plusieurs circuits d'entrée reliés en commun à ladite borne de sortie commune, chacun desdits circuits d'entrée comprenant: une borne d'entrée ($T_0$, $T_1$, $T_2$, $T_3$), un circuit tampon ($I_0$, $I_1$, $I_2$, $I_3$), et un transistor de type métal-isolant-semiconducteur (MIS) ($Q_4$, $Q_5$, $Q_6$, $Q_7$), les régions de source et de drain dudit transistor à isolation métallique étant connectées à ladite borne d'entrée et à ladite borne de sortie, ledit circuit tampon étant inséré entre ladite borne d'entrée et l'électrode de grille dudit transistor MIS, ledit circuit tampon étant commandé par ledit signal de ligne de mot ($\Theta_0$, $\Theta_1$, $\Theta_2$, $\Theta_3$) qui est appliqué de façon sélective à ladite borne d'entrée, et ledit transistor MIS étant commandé par ledit circuit tampon afin d'être rendu conducteur, de sorte que ledit signal de ligne de mot soit transmis de façon sélective de ladite borne d'entrée à ladite borne de sortie.

**Ansprüche**

1. Signalsendeschaltung mit einem gemeinsamen Ausgangsanschluß (Ts) und einer Vielzahl von Eingangsschaltungen, die gemeinsam mit dem genannten gemeinsamen Anschluß verbunden sind, bei welcher jede der genannten Schaltungen umfaßt:
- einen Eingangsanschluß ($T_0$, $T_1$, $T_2$, $T_3$)
- eine Pufferschaltung ($I_0$, $I_1$, $I_2$, $I_3$); und
- einen Metallisolatorhalbleiter-(MIS)-Transistor ($Q_4$, $Q_5$, $Q_6$, $Q_7$), wobei der Sourcebereich und der Drainbereich des genannten MIS-Transistors mit dem genannten Eingangsanschluß und dem genannten Ausgangsanschluß verbunden sind,
- die genannte Pufferschaltung zwischen dem genannten Eingangsanschluß und der Gateelektrode des genannten MIS-Transistors eingefügt ist und durch ein Eingangssignal ($\phi_0$, $\phi_1$, $\phi_2$, $\phi_3$) selektiv dem genannten Eingangsanschluß zugeführt werden, und
- der genannte MIS-Transistor von der genannten Pufferschaltung betrieben wird, um leitend gemacht zu werden, wodurch zugelassen wird, daß das genannte Eingangssignal von dem genannten Eingangsanschluß selektiv zu dem genannten Ausgangsanschluß gesendet wird.

2. Signalsendeschaltung nach Anspruch 1, bei dem der genannte MIS-Transistor ($Q_4$, $Q_5$, $Q_6$, $Q_7$) vom p-Kanal-Typ ist und die genannte Pufferschaltung einen cMOS-Inverter ($I_0$, $I_1$, $I_2$, $I_3$) umfaßt.

3. Signalsendeschaltung nach Anspruch 1, bei der der genannte MIS-Transistor ($Q_{10}$, $Q_{15}$, $Q_{16}$, $Q_{17}$) vom n-Kanal-Typ ist und die genannte pufferschaltung ($B_0$, $B_1$, $B_2$, $B_3$) zwei cMOS-Inverter umfaßt, die in Reihe verbunden sind.

4. Speichervorrichtung mit:
einem realen Speicherzellenfeld, das eine Matrix bildet, die eine Vielzahl von Reihen von realen Speicherzellen (MC) umfaßt, um Information zu speichern;
einem Referenzspeicherzellenfeld, das eine Vielzahl von Reihen von Referenzspeicherzellen ($MC_R$) umfaßt, um Referenzsignale ($V_{R1}$, $V_{R2}$, $V_{R3}$) zu erzeugen, wobei jede Referenzreihe eines einer vorbestimmten Zahl von Referenzsignalen erzeugt;
einer Reihe von Blindspeicherzellen, jeweils zum Simulieren des Sendens eines Wortleitungssignals ($\phi_0$, $\phi_1$, $\phi_2$, $\phi_3$), welches der genannten Reihe von realen Speicherzellen und der genannten Reihe von Referenzzellen zugeführt wird; und
einer Signalsendeschaltung zum gleichzeitigen Senden der genannten Wortleitungssignale ($\phi_0$ $\phi_1$, $\phi_2$, $\phi_3$) an eine ausgewählte Reihe von realen Speicherzellen, alle Reihen der genannten Referenzspeicherzellen und die genannte Reihe von Blindspeicherzellen, dadurch gekennzeichnet, daß die Signalsendeschaltung (Fig. 9) einen gemeinsamen Ausgangsanschluß (TS) und eine Vielzahl von Eingangsschaltungen umfaßt, die gemeinsam mit dem gemeinsamen Ausgangsanschluß verbunden sind, wobei jede der genannten Eingangsschaltungen umfaßt:
einen Eingangsanschluß ($T_0$, $T_1$, $T_2$, $T_3$), eine Pufferschaltung ($I_0$, $I_1$, $I_2$, $I_3$) und einen Metallisolatorhalbleiter-(MIS)-Transistor ($Q_4$, $Q_5$, $Q_6$, $Q_7$), wobei der Sourcebereich und der Drainbereich des genannten MIS-Transistors mit dem genannten Eingangsanschluß und dem genannten Ausgangsanschluß verbunden sind, die genannte Pufferschaltung zwischen dem genannten Eingangsanschluß und der Gateelektrode des genannten MIS-Transistors eingefügt ist und die genannte Pufferschaltung durch das genannte Wortleitungssignal ($\phi_0$, $\phi_1$, $\phi_2$, $\phi_3$) getrieben

wird, welches selektiv dem genannten Eingangsanschluß zugeführt wird, und der genannte MIS-Transistor durch die genannte Pufferschaltung getrieben wird, um leitend gemacht zu werden, wodurch bewirkt wird, daß das genannte Wortleitungssignal selektiv von dem genannten Eingangsanschluß zu dem genannten Ausgangsanschluß gesendet wird.

# FIG. 1

# FIG.2

channel width

FIG. 3

FIG. 4

FIG.5

EP 0 151 083 B1

FIG.6

common decoder

reference cell column decoder

reference cell array

reference cell block 1    $MCB_R1$
   "    2    $MCB_R2$
   "    3    $MCB_R3$

reference decoder

real cell block 1    $MCB\ 1$
   "    2    $MCB\ 2$
   "    3    $MCB\ 3$

real cell block decoder

real cell array

real cell block 255    MCB 255
   "    256    MCB 256

dummy cell block

DET

real cell column decoder

CK

$V_{R1}$

$V_{R2}$

$V_{R3}$

$D_1$ ← logic circui ← $O_1$ $O_2$ $O_3$ ← sense amplifier ← CK   SA1

$D_2$ ←

$O_2$ ← sense amplifier ← CK   SA2

$O_3$ ← sense amplifier ← CK   SA3

# FIG.7

# FIG.8

PRIOR ART

block decoder

reference cell block

# FIG. 9

transmission circuit

reference cell block
(dummy)

$BL_1$ $BL_2$ $BL_3$ $BL_{255}$ $BL_{256}$